# EUROPEAN PATENT APPLICATION

(11) **EP 1 180 791 A1**
(43) Date of publication of application: **20.02.2002**
(21) Application number: 00117836.7
(22) Date of filing: 18.08.2000
(51) Int. Cl.: H01L 21/318

(54) **Method for forming a nitride layer on a semiconductor substrate**

(71) Applicant: Infineon Technologies SC300 GmbH & Co. KG, 01099 Dresden (DE)
(72) Inventor: Köstler, Wolfram, 01465 Langebrück (DE)
(74) Representative: Hermann, Uwe, Dipl.-Ing.

(57) **Abstract**

A semiconductor substrate (1) with an oxide layer (2) attached to said semiconductor substrate (1) is arranged in a process chamber. Said oxide layer (2) is sublimated from solid to gaseous phase. A nitride layer (3) is formed on said semiconductor substrate (1). Advantageously, said oxide layer (2) is removed from said semiconductor substrate (1) without contaminating said semiconductor substrate (1).

## Description

The present invention relates to a method for forming a nitride layer on a semiconductor substrate.

In the technical field of semiconductors, it is common to use silicon as a semiconductor material. For manufacturing a capacitor with a high capacitance, it is known to use silicon oxide or silicon nitride as a dielectric layer in the capacitor. Because silicon oxide has a lower dielectric constant compared to silicon nitride, it is preferred to use a silicon nitride layer instead of a silicon oxide layer to increase the capacitance of the capacitor. It is known from the state of the art, that an ex-situ wet clean is performed with the substrate before manufacturing the capacitor. Because the cleaning is performed in environmental conditions, a native oxide layer with a thickness of roughly 0,7 to 1,0 nm is still contaminating the surface of a semiconductor substrate. A following nitridation step is growing an oxygen contaminated silicon nitride instead of a pure silicon nitride. The oxygen contamination reduces the dielectric constant of the dielectric layer, so that the capacitance of the capacitor is reduced.

There are process steps known from prior art to clean a substrate from oxygen before forming a nitride layer. One is to arrange the oxygen contaminated substrate in a process chamber and to process a prebake at roughly 950 °C in hydrogen atmosphere. Another possibility is to process the oxygen contaminated substrate in a process chamber at roughly 950 °C in an atmosphere containing hydrogen and silan. The two mentioned processes do not clean the substrate from oxygen with the desired pureness. The silan and the hydrogen tend to contaminate the substrate.

The mentioned processes are inadequate to remove all the oxygen from the surface of the substrate. Oxygen can still be detected an the surface. Problems also arise because of chemical reactions between the hydrogen and the dopants which take place in a layer near the surface of the substrate.

It is an objective of the present invention to provide another method for forming a nitride layer on a semiconductor substrate which reduces the contamination of the semiconductor substrate.

This objective is solved by a method for forming a nitride layer on a semiconductor substrate comprising the steps:
- Arranging said semiconductor substrate with an oxide layer attached to said semiconductor substrate in a process chamber;
- sublimating said oxide layer from solid to gaseous phase.
- nitridating said semiconductor substrate to form a nitride layer.

The provided method is not using aggressive chemicals to remove the oxygen layer, so that a contamination of the substrate is avoided. Another advantage of the inventive method is, that the sublimation of the oxide layer from solid to gaseous phase can be performed in a process chamber which is capable of performing the process steps following the removing of the oxide layer, resulting in an in situ process. The sublimation is capable of cleaning a surface of a substrate in a way that oxygen can not be detected any more.

In a further embodiment of the invention evacuates said process chamber to a pressure of less than 10⁻⁸ torr (UHV). Preferably, the UHV-pressure avoids contamination of the substrate in the process chamber.

According to another embodiment, said semiconductor substrate is heated to a temperature between 550°C to 1000°C. Advantageously, the temperatures between 550°C and 1000°C are adequate to sublimate an oxide layer from solid to gaseous phase.

Advantageously, the present invention comprises the step of depositing a further nitride layer on said nitride layer. Advantageously, the formed nitride layer is less contaminated with oxygen compared to the state of the art.

In the following, the present invention is described according to an embodiment of the invention, taken in conjunction with the accompanying drawings, wherein
- figure 1: shows a semiconductor substrate with an oxygen contamination;
- figure 2: shows a semiconductor substrate with a nitride layer.

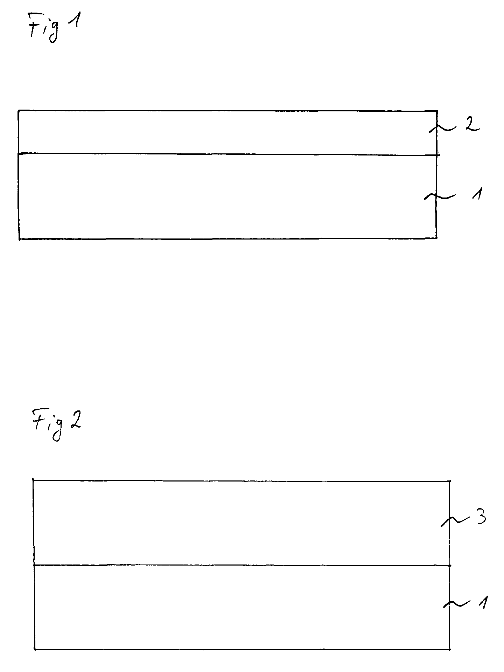

Figure 1 shows a semiconductor substrate 1 and an oxide layer 2 which is attached to the semiconductor substrate 1. In an embodiment of the invention the semiconductor substrate 1 comprises silicon and the oxide layer 2 comprises silicon oxide. According to the invention, the semiconductor substrate 1 is arranged in a process chamber and the oxide layer 2 is sublimated from solid to gaseous phase.

According to figure 2, the oxide layer 2 has been removed and a nitride layer 3 has been arranged on the semiconductor substrate 1. The nitride layer 3 can be built by nitridation at 950 °C in ammoniac atmosphere in the process chamber. Afterwards, the thickness of the nitride layer 3 can be increased by LPCVD-deposition (low pressure chemical vapour deposition) of silicon nitride. LPCVD is performed at a pressures between 0,5 and 2 mbar and a temperature between 400°C to 1000°C.

It is preferred to heat the substrate 1 to a temperature between 550°C and 1000°C to sublimate the oxide layer 2. It is also preferred to evacuate the process chamber to a pressure of less than 10⁻⁸ torr, so that a further contamination of the substrate 1 is avoided.

It is also preferred to perform an ex-situ wet clean of the substrate 1 to remove a thick oxygen layer 2. The removal of a thick oxygen layer 2 can be performed with hydrofluoric acid and rinsing afterwards. The ex-situ cleaning means that the substrate 1 is handled in environmental conditions, which can lead to a thin layer of native oxide.

List of references
- 1: Semiconductor substrate
- 2: Oxide layer
- 3: Nitride layer

## Claims

1. Method for forming a nitride layer on a semiconductor substrate comprising the steps:
- arranging said semiconductor substrate (1) with an oxide layer (2) attached to said semiconductor substrate (1) in a process chamber;
- sublimating said oxide layer (2) from solid to gaseous phase;
- nitridating said semiconductor substrate (1) to form a nitride layer (3).

2. A method according to claim 1,
**comprising the step of**
evacuating said process chamber to a pressure of less than 10⁻⁸ torr.

3. A method according to one of the claims 1 or 2,
**comprising the step of**
heating said semiconductor substrate (1) to a temperature between 550°C and 1000°C.

4. A method according to one of the claims 1 to 3,
**comprising the step of**
depositing a further nitride layer on said nitride layer (3).
